# EUROPÄISCHE PATENTSCHRIFT

(11) **EP 3 439 178 B1**
(45) Veröffentlichungstag und Bekanntmachung des Hinweises auf die Patenterteilung: **30.03.2022**
(21) Anmeldenummer: 18175571.1
(22) Anmeldetag: 01.06.2018
(51) Int. Cl.: H03K 17/95, H03K 17/96

(54) **TÜRGRIFFANORDNUNG FÜR EIN KRAFTFAHRZEUG MIT KAPAZITIVEM UND INDUKTIVEM SENSOR**
DOOR HANDLE ASSEMBLY FOR A MOTOR VEHICLE WITH CAPACITIVE AND INDUCTIVE SENSOR
AGENCEMENT DE POIGNÉE DE PORTE POUR UN VÉHICULE AUTOMOBILE DOTÉ DU CAPTEUR CAPACITIF ET DU CAPTEUR INDUCTIF

(30) Priorität: 03.08.2017 DE 102017117646
(43) Veröffentlichungstag der Anmeldung: 06.02.2019
(73) Patentinhaber: Huf Hülsbeck & Fürst GmbH & Co. KG, 42551 Velbert (DE)
(72) Erfinder: SIEG, Berthold, 46240 Bottrop (DE)
(74) Vertreter: Zenz Patentanwälte Partnerschaft mbB

(56) Entgegenhaltungen:
- EP-A1- 0 751 403
- DE-A1-102015 100 074
- GB-A- 2 409 842

## Beschreibung

Die Erfindung betrifft eine Sensoreinrichtung für ein Kraftfahrzeug, die eine wenigstens einschichtige Leiterplatte aufweist. Auf der Leiterplatte ist wenigstens eine Sensorelektrode eines kapazitiven Annäherungssensors ausgebildet. Außerdem ist wenigstens ein induktiver Sensor vorgesehen, der ebenfalls auf der Leiterplatte angeordnet ist. Eine Steuerelektronik ist Bestandteil der Sensoreinrichtung, welche sowohl mit der Sensorelektrode als auch dem induktiven Sensor gekoppelt ist.

Sensoreinrichtungen mit integrierten kapazitiven Sensoren sind im Stand der Technik hinlänglich bekannt, insbesondere auch deren Anwendung in Türaußengriffen von Kraftfahrzeugen. Beispielsweise offenbart das Dokument DE 196 17 038 A1 einen Türgriff mit kapazitiven Sensoren, welche die Annäherung eines potenziellen Bedieners erfassen.

Ein solcher kapazitiver Annäherungssensor umfasst eine Sensorelektrode und eine Steuerelektronik als Ansteuer- und Auswerteschaltung. Die Steuerelektronik ermittelt die Kapazität der Sensorelektrode gegenüber Masse oder einem anderen Bezugspotenzial. Durch die Annäherung einer Hand des Bedieners an die Sensorelektrode wird die Kapazität der Sensorelektrode verändert, was durch die Steuerelektronik erfasst wird. Sobald ein solcher Sensor eine Annäherung erfasst, kann in Abhängigkeit von der Erfassung eine Funktion ausgelöst werden, beispielsweise kann ein Wecksignal eines Keyless-Entry-Systems an einen Fahrzeugschlüssel des Benutzers ausgesandt werden.

Als Sensoreinrichtung mit einem alternativen Erfassungskonzept sind induktive Sensoren bekannt, die zunehmend im Bereich der Fahrzeugtechnik und Fahrzeugtürgriffe Einsatz finden. Derartige induktive Sensoren sind üblicherweise darauf angewiesen, dass die Bewegung eines leitfähigen, insbesondere metallischen Gegenstandes detektiert wird. Bezüglich solcher Bewegungen sind diese induktiven Sensoren sehr sensitiv und genau. Häufig werden daher metallische Komponenten im Türgriff angeordnet, die gegenüber einem Sensor, der beispielsweise eine Induktionsspule aufweist, durch Benutzereingriff bewegt werden. Diese Bewegungen können äußert klein sein, zum Beispiel die Verformung des Türgriffs durch einen mechanischen Zug betreffen.

Die Kombination von kapazitiven und induktiven Sensoren stellt unterschiedliche sensitive Bedienkonzepte für verschiedene Bedienaufgaben bereit. Beispielsweise können die Funktionen einer kapazitiven Sensoranordnung zur Triggerung eines schlüssellosen Zugangssystems verwendet werden, wogegen die induktiven Sensoren für konkrete Bedienbefehle am Türgriff eingesetzt werden können, zum Beispiel für eine Betätigung eines Schließmechanismus oder die Ansteuerung weiterer Funktionen (beispielsweise Offnen sämtlicher Fenster) über den Türgriff.

Dokument GB2409842 offenbart eine solche Anordnung mit kapazitiven und induktiven Sensoren.

Der Bauraum innerhalb eines Bedienelementes am Fahrzeug, insbesondere im Türgriff, ist sehr begrenzt. Entsprechend ist es angesichts der Gefahr wechselseitiger Beeinflussung regelmäßig problematisch, mehrere Sensoren auf beengtem Raum und in unmittelbarer Nähe zueinander anzuordnen.

Aufgabe der Erfindung ist es, eine verbessere Sensoreinrichtung für Kraftfahrzeuge zur Verfügung zu stellen, die eine verbesserte Bauraumnutzung mit kapazitiven sowie induktiven Sensoren verwendet.

Diese Aufgabe wird gelöst durch eine Sensoreinrichtung mit den Merkmalen des Patentanspruches 1.

Die erfindungsgemäße Sensoreinrichtung der eingangs genannten Art weist als Bestandteil der Sensorelektrode wenigstens einen langgestreckten Basisleiter auf, der auf der wenigstens einschichtigen Leiterplatte ausgebildet ist. Ausgehend von dem Basisleiter erstreckt sich eine Mehrzahl von Abzweigleitern, die voneinander beabstandet sind und ausschließlich über den Basisleiter galvanisch gekoppelt sind. Der Basisleiter bildet demnach eine Art Verteilerstrecke, von der aus sich beabstandet die Abzweigleiter verzweigen.

Weiterhin ist der wenigstens der eine induktive Sensor so an oder auf der Leiterplatte angeordnet, dass er entlang der Längserstreckung des Basisleiters angeordnet ist, jedoch beabstandet davon. Er befindet sich also auf der Platine in einem Bereich, welcher von einer Projektion des Basisleiters in der Platinenebene überspannt wird. Dabei steht der Basisleiter mit dem induktiven Sensor nicht in galvanischem Kontakt, sondern ist vielmehr von diesem galvanisch entkoppelt. Die Abzweigleiter erstrecken sich jedoch so von dem Basisleiter ausgehend, dass sie sich in Richtung des induktiven Sensors erstrecken und diesen, zumindest entlang eines Umfangabschnitts des induktiven Sensors, beabstandet umgeben.

Die Erfindung zeichnet demnach einerseits eine besondere Gestaltung der Sensorelektrode mit einem Basisleiter und einer Mehrzahl von Abzweigleitern aus, die gemeinsam eine Elektrodenfläche bilden, jedoch durch die verzweigte Struktur von beabstandeten Abzweigleitern, die über den Basisleiter miteinander gekoppelt sind.

Andererseits wird der induktive Sensor in Freibereichen der Sensorelektrode angeordnet, die durch die Abzweigleiter gebildet werden. Die Abzweigleiter verlaufen jederzeit in einem vorgegebenen Abstand um den induktiven Sensor herum oder sind in ihrer Länge so ausgebildet, dass sie diesen Abstand einhalten.

Es ist damit sichergestellt, dass die Sensorelektrode mit ihren elektrisch leitfähigen Abzweigleitern ausreichenden Abstand zu den induktiv wirksamen Sensoren hält. Weiterhin wird durch die Gestaltung der Sensorelektrode mit Basisleitern und einer Mehrzahl von Abzweigleitern erreicht, dass ein Risiko der Ausbildung von Wirbelströmen in der Sensorelektrode erheblich reduziert wird.

Die Sensorelektrode ist mit dieser besonderen Geometrie ausgebildet, um der Induktion von Wirbelströmen, wie sie grundsätzlich bei dem Betrieb der induktiven Sensoren hervorgerufen werden können, reduziert. Wirbelströme in der kapazitiven Sensorelektrode sind nachteilig, da sie ein Magnetfeld hervorbringen, welches dem erzeugenden Magnetfeld entgegenwirkt und damit das erzeugende Magnetfeld schwächt und zugehörige Detektionsfähigkeit herabsetzt. Erfindungsgemäß ist die Sensorelektrode mit dem langgestreckten Basisleiter ausgebildet und einer Mehrzahl von Abzweigleitern die sich von dem Basisleiter ausgehend gleichsam wie Zweige erstrecken.

Die induktiven Sensoren und auch die kapazitive Sensorelektrode werden in herkömmlicher Weise, also beispielsweise wie im oben genannten Stand der Technik beschrieben, angesteuert. Durch die Gestaltung der Sensorelektrode mit ihren Abzweigleitern wird vermieden, dass eine geschlossene Leiterschleife um die induktiven Sensoren und deren Spulen gebildet wird, was einen magnetischen Kurzschluss verursachen könnte und die Funktion der induktiven Sensoren negativ beeinflussen würde.

Diese Abzweigleiter weisen auf ihrer dem Basisleiter abgewandten Seite freie, also nicht elektrisch mit weiteren Bauteilen gekoppelte Enden auf. Der Basisleiter bildet mit den Abzweigleitern zusammen die Sensorelektrode. Die Abzweigleiter und auch der Basisleiter können grundsätzlich beliebige Formen annehmen, sie dürfen jedoch miteinander und mit dem Basisleiter keine geschlossenen Ringstrukturen bilden, in denen sich größere Wirbelstrombereich ausbilden können. Erfindungsgemäß wird auf diese Weise eine Sensorelektrode gebildet, die einen Detektionsbereich ausbildet, der jedoch nur teilweise mit Leiterstrukturen belegt ist und keinen Raum für die Ausbildung größerer Wirbelstrombereiche bietet. Es hat sich gezeigt, dass auf diese Weise sowohl eine verlässliche Detektion des kapazitiven Sensors möglich ist, als auch ein ungestörter Betrieb der induktiven Sensoren. Da ein Flächenbereich der Leiterplatte raumoptimiert für die kapazitive Sensorelektrode als auch für die induktiven Sensoren genutzt werden kann, ist eine kompaktere Bauform der Sensoreinrichtung möglich, oder aber eine weitere Erstreckung des sensitiven Bereichs der kapazitiven Sensoreinrichtung oder der induktiven Sensoren.

In einer Weiterbildung der Erfindung sind sämtliche Abzweigleiter gerade ausgebildet und erstrecken sich in einem einheitlichen Abzweigwinkel zu dem Basisleiter. Gemäß dieser Ausführungsform ist eine besonders gute Flächennutzung möglich, wobei sich die Abzweigleiter entlang einer Geraden von dem Basisleiter ausgehend erstrecken, beispielsweise in einem Winkel von 90 °C, so dass aus den Basisleitern und den Abzweigleitern eine Art Kammstruktur gebildet wird. Der Basisleiter kann dabei grundsätzlich ebenfalls als gerade Leiterbahn ausgebildet sein, er kann jedoch auch gekrümmt oder geschwungen oder gewinkelt ausgebildet sein.

In einer Weiterbildung der Erfindung ist der induktive Sensor mit wenigstens einer Spulenanordnung ausgebildet, die als spiralförmige Leiterbahn auf der Leiterplatte ausgebildet ist. Grundsätzlich ist die Erfindung auch mit oberflächenmontierten Bauteilen einsetzbar, die Ausbildung von gedruckten Strukturen als Leiterbahnen, welche induktiv detektionsfähige Spulen auf der Leiterplatte selbst ausbilden ist jedoch eine besonders bevorzugte Gestaltung der Erfindung. Die spiralförmige Leiterbahn kann in einer Ebene der Leiterplatte gebildet sein oder sich auch grundsätzlich über mehrere Ebenen der Leiterplatte erstrecken. Insbesondere kann die spiralförmige Leiterbahn an ihrer Innenseite und Außenseite durch Kontaktierungen zu weiteren Leiterplattenebenen aufweisen oder zur Rückseite einer einschichtigen Leiterplatte, um die spiralförmige Leiterbahn als induktiven Sensor zu nutzen. Dabei kann die spiralförmige Leiterbahn auf derselben Ebene ausgebildet sein wie die Sensorelektrode mit ihrem Basisleiter und den Abzweigleitern.

Diese Ausgestaltung erlaubt eine äußerst einfache Herstellung, da sowohl die induktiven Sensoren als auch die Sensorelektrode in einem Arbeitsschritt erstellt werden können.

Es ist bevorzugt, dass jeder Abzweigleiter sich von einer über seine gesamte Länge konstanten Breite von dem Basisleiter aus erstreckt. Die Ausbildung der Abzweigleiter mit konstanter Breite begünstigt eine gleichmäßigere Sensitivität der Sensorelektrode.

In einer Weiterbildung der Erfindung ist die Breite der Abzweigleiter in Abhängigkeit von der Entfernung von dem induktiven Sensor gewählt, wobei die Breite der Abzweigleiter mit größerem Abstand von dem induktiven Sensor zunimmt.

Die Ausbildung von Wirbelströmen ist in räumlicher Nähe zu den Spulen eines induktiven Sensors am größten. Entsprechend sind dort die Abzweigleiter der erfindungsgemäßen Sensoranordnung besonders schmal ausgebildet. Mit zunehmenden Abstand von dem induktiven Sensor können die breiteren Leiter angesichts der geringeren Wirkung nur noch in geringerem Ausmaß Wirbelströme ausbilden. Entsprechend werden also die Abzweigleiter mit uneinheitlicher Breite gebildet, um einerseits eine möglichst große Fläche der Sensorelektrode bereitzustellen und andererseits die Einflüsse von Wirbelströmen möglichst gering zu halten.

Gemäß einer bevorzugten Weiterbildung der Erfindung weisen die Abzweigleiter der kapazitiven Elektrode zu ihren jeweils benachbarten Abzweigleitern einheitliche Abstände auf. Auch dieser Aspekt der Konstruktion begünstigt einerseits eine einfache Herstellung und andererseits eine einheitliche Sensitivität der Sensorelektrode über die gesamte Erstreckung des Basisleiters.

Gemäß einer bevorzugten Ausführungsform betragen die Abstände zwischen benachbarten Abzweigleitern zwischen dem 0,5-Fachen und dem 5-Fachen der größeren Breite der benachbarten Abzweigleiter. Die Breite der Abzweigleiter liegt also grundsätzlich in derselben Größenordnung wie die Abstände, es ist jedoch, je nach gewünschter Sensitivität und Geometrie der Einrichtung möglich, Abstände vorzusehen, die geringer als die Breiten der Abzweigleiter sind oder Abstände vorzusehen, die die Breite der Abzweigleiter übersteigen.

Gemäß einer bevorzugten Ausführungsform der Erfindung weisen die Abzweigleiter Breiten zwischen 0,1 mm und 1 mm auf und die Abstände liegen zwischen 0,1 mm und 1 mm.

Die Anzahl der Abzweigleiter kann in Abhängigkeit von dem bereitstehenden Raum gewählt werden, liegt jedoch regelmäßig zwischen 10 und 200.

In einer Weiterbildung der Erfindung ist nicht nur ein Basisleiter ausgebildet, sondern die kapazitive Sensorelektrode weist zwei Basisleiter auf, denen jeweils Abzweigleiter zugeordnet sind, die sich von den Basisleitern aus verzweigen. Die Basisleiter sind dabei auf zwei Seiten des induktiven Sensors auf der Leiterplatte platziert und die Abzweigleiter jedes der Basisleiter verzweigen in Richtung der Spulenanordnung.

Gemäß dieser Ausführungsform ist es möglich, weiteren Platz auf der Leiterplatte für die Sensorelektrode zu nutzen, da die Basisleiter auf zwei, beispielsweise voneinander abgewandten Seiten des induktiven Sensors angeordnet werden. Die Abzweigleiter erstrecken sich in Richtung des induktiven Sensors und können diesen gleichsam umgreifen, so dass der gesamte bereitstehende Platz auf der Leiterplatte, welcher sich in einem ausreichenden Abstand von dem induktiven Sensor befindet für die Ausbildung des kapazitiven Sensors verwendet werden. Die beiden Basisleiter bilden jedoch keine geschlossene Ringstruktur um die induktiven Sensoren.

In einer Weiterbildung der Erfindung sind diese beiden Basisleiter mit der Steuereinrichtung gekoppelt, um sie zu einer Sensorelektrode zusammenzufassen, jedoch sind die beiden Basisleiter ansonsten galvanisch voneinander entkoppelt. Dies begünstigt wiederum die Unterdrückung von Wirbelströmen, da die entkoppelten Basisleiter keine um den induktiven Sensor herum erreichende geschlossene Leiterschleife bilden. Sie sind ausschließlich durch die gemeinsame Kopplung mit der Steuerelektronik gekoppelt.

In einer weiteren bevorzugten Ausführungsform der Erfindung weist die Sensoreinrichtung eine Mehrlagenplatine auf, wobei in einer weiteren Lage der Mehrschichtplatine zu der Sensorelektrode und der diese Sensorelektrode bildenden Struktur eine deckungsgleiche Elektrode als Schirmelektrode oder als Bezugselektrode ausgebildet ist. Diese Elektrode kann entsprechend ebenfalls ebenso viele Basisleiter aufweisen wie die Sensorelektrode auf der Hauptebene und zu einer verbesserten Sensierung mit der Sensorelektrode beitragen Entsprechende Konzepte mit der Anordnung von Schirmelektroden, die beispielsweise auf demselben Potenzial gehalten werden wie die Sensorelektroden selbst oder in ihrem Potenzial zur Erhöhung der Sensitivität gezielt geändert werden, sind aus dem Stand der Technik hinlänglich bekannt.

Die Erfindung wird nun anhand der beiliegenden Zeichnungen näher erläutert.
Figur 1 zeigt schematisch die Anordnung einer erfindungsgemäßen Sensoreinrichtung in einem Fahrzeugtürgriff;
Figur 2 zeigt schematisch die Anordnung der erfindungswesentlichen Komponenten in einer Ebene einer Leiterplatte gemäß einer ersten Ausführungsform der Erfindung;
Figur 3 zeigt die Anordnung der erfindungswesentlichen Komponenten auf einer Ebene einer Leiterplatte gemäß einer zweiten Ausführungsform der Erfindung.

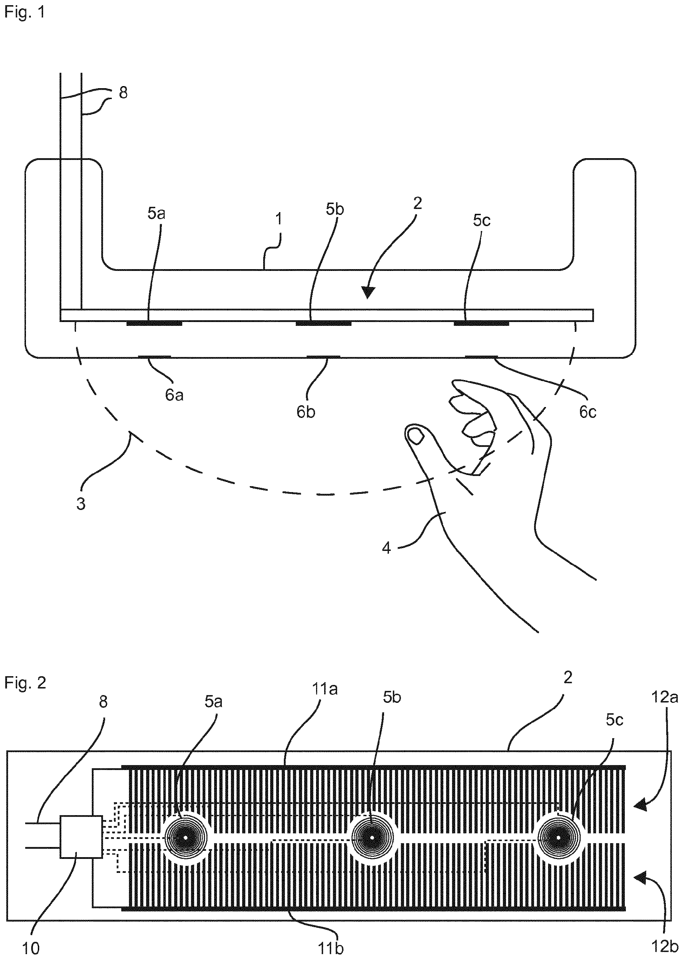

In Figur 1 ist ein Fahrzeugtürgriff 1 gezeigt. Der Fahrzeugtürgriff 1 weist eine Leiterplatte 2 mit einer darauf angeordneten Sensoreinrichtung auf. Die Sensoreinrichtung auf der Leiterplatte 2 weist einen kapazitiven Annäherungssensor auf, der einen Detektionsbereich 3 aufspannt. Bewegt sich die Hand 4 eines Benutzers in dem Detektionsbereich hinein, kann durch eine Detektion einer Kapazitätsänderung des kapazitiven Sensors auf der Leiterplatte 2 dieser Annäherung erkannt werden. Außerdem sind auf der Leiterplatte 2 drei induktive Sensoren 5a, 5b und 5c angeordnet. Diesen gegenüber, auf der Innenseite des Gehäuses des Türgriffes 1 angeordnet sind jeweils Metallbleche 6a, 6b und 6c. Bei einer Verformung des Gehäuses des Fahrzeugtürgriffes 1, beispielsweise durch eine Druckbeaufschlagung des Bereiches, in dem die Metallbleche 6a, 6b oder 6c angeordnet sind, verändert sich die Lage oder der Abstand der Metallbleche 6a, 6b oder 6c gegenüber den zugeordneten induktiven Sensoren 5a, 5b und 5c. Auf diese Weise sind Betätigungen am Fahrzeugtürgriff 1 ohne Ausbildung von störanfälligen und Verschmutzungsanfälligen Schalterausnehmungen realisierbar. Die Leiterplatte 2 ist durch Steuer- und Signalleitungen 8 mit einem Fahrzeugsystem (nicht gezeigt) verbunden.

Figur 2 zeigt eine Leiterplatte 2 gemäß einer ersten Ausführungsform der Erfindung. Auf der Leiterplatte 2 ist eine Steuereinrichtung 10 mit integrierter Elektronik, insbesondere mit einem Mikrocontroller ausgebildet. Die Steuerelektronik 10 ist durch die Steuer- und Versorgungsleitungen 8 mit dem Fahrzeug gekoppelt. Auf der Leiterplatte 2 sind drei spiralförmige Leiteranordnungen 5a, 5b, 5c ausgebildet. Diese spiralförmigen Leiterbahnen bilden jeweils eine Spulenanordnung, die wesentlicher Bestandteil eines induktiven Sensors ist. Die Spulen sind zu der Rückseite der Leiterplatte 2 oder einer weiteren Ebene der Leiterplatte 2 jeweils endseitig durchkontaktiert und mit der Steuereinrichtung 10 verbunden. Die Verbindungen der Spuleneinrichtungen 5a, 5b, 5c mit der Steuereinrichtung 10 sind als gebrochene Linien dargestellt. Auf zwei voneinander abgewandten Seiten der Spuleneinrichtungen 5a, 5b und 5c sind Basisleiter 11a und 11b angeordnet. Diese sind voneinander beabstandet und zumindest an der rechten Endseite galvanisch voneinander getrennt, jedoch über die Steuereinrichtung 10 gekoppelt. Ausgehend von den Basisleitern 11a und 11b weisen kammartig abzweigende Abzweigleiter 12a und 12b in Richtung der Spulenanordnungen 5a, 5b und 5c. Es ist ersichtlich, dass die Abzweigleiter 12a und 12b in einem Abstand zu ihren jeweils benachbarten Abzweigleitern erstrecken und in der Mitte der Platine getrennt von den gegenüberliegenden Abzweigleitern enden. Um die Spulenanordnungen 5a, 5b und 5c herum sind Freibereiche ausgebildet, in welchen die Abzweigleiter jeweils geringere Längen aufweisen, um einen Abstand der Leiterstrukturen von den Spulen zu gewährleisten.

Die Beabstandung der Abzweigleiter 12a und 12b unterbindet eine Ausbildung von Wirbelströmen, die einen größeren Durchmesser aufweisen als die jeweiligen Leiterbreiten der Abzweigleiter. Es ist unmittelbar ersichtlich, dass die Ausbildung der Wirbelströme, hervorgerufen durch die Induktivitäten der aktivierten Spulenanordnungen 5a, 5b und 5c, auf diese Weise signifikant reduziert werden können. Dennoch ist ein erheblicher Bereich der Leiterplatte 2 als kapazitivsensitiver Bereich ausgebildet, da die Abzweigleiter zusammen mit den Basisleitern einen wesentlichen Teil der Fläche überdecken und die Beabstandung der Abzweigleiter voneinander dennoch eine sensitive Erfassung über die kapazitive Auswertung erlaubt.

Es ist in diesem ersten Ausführungsbeispiel entsprechend realisiert, drei verschiedene induktive Sensoren mit Spulenanordnungen 5a, 5b und 5c anzuordnen, die im selben Flächenbereich der Sensorelektrode aktiv sind wie ein kapazitiver Sensor, ohne die erfassungsstörenden Wirbelströme ausbilden zu können.

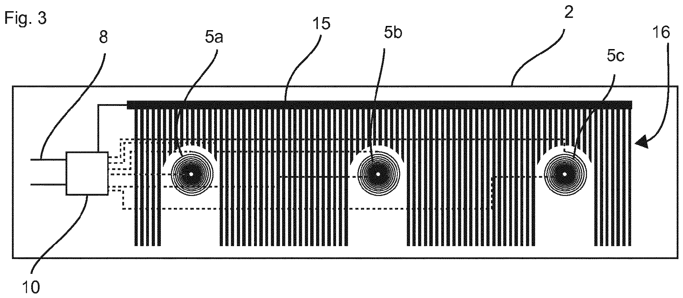

Figur 3 zeigt eine alternative Gestaltung gemäß einem weiteren Ausführungsbeispiel der Erfindung. In diesem Ausführungsbeispiel ist auf der Leiterplatte wiederum eine Steuereinrichtung 10 mit Versorgungs- und Steuerleitungen 8 ausgebildet und auch die Spulenanordnungen 5a, 5b und 5c sind identisch zum ersten Ausführungsbeispiel platziert. In dieser Ausführungsform ist jedoch nur ein einziger Basisleiter 15 ausgebildet, von dem aus sich die Abzweigleiter 16 in Richtung der Spulenanordnungen 5a, 5b und 5c erstrecken. Auf diese Weise wird eine gewisse Asymmetrie der Leiterstruktur der kapazitiven Sensorelektrode aus den Komponenten 15 und 16 in Kauf genommen, die Leiterplatte stellt jedoch weitere Bereiche zur Verfügung, die ggf. mit Funktionskomponenten gefüllt werden können. Wesentlich ist auch hier, dass die Ausbildung von Wirbelströmen in der Leitstruktur der kapazitiven Sensorelektrode unterbunden werden kann.

## Patentansprüche

1. Sensoreinrichtung für ein Kraftfahrzeug, aufweisend eine wenigstens einschichtige Leiterplatte (2), auf welcher wenigstens eine Sensorelektrode (11a, 12a, 11b, 12b; 15, 16) wenigstens eines kapazitiven Sensors ausgebildet ist,
wenigstens einen induktiven Sensor (5a, 5b, 5c), der auf der Leiterplatte (2) angeordnet ist,
eine Steuereinrichtung (10), welche mit der Sensorelektrode (11a, 12a, 11b, 12b; 15, 16) und dem induktiven Sensor (5a, 5b, 5c) gekoppelt ist,
wobei die Sensorelektrode wenigstens einen langgestreckten Basisleiter (11a, 11b; 15) aufweist und eine Mehrzahl von Abzweigleitern (12, 12b; 16), die sich von dem Basisleiter abgehend erstrecken,
wobei die Abzweigleiter (12, 12b; 16) sich entlang des Basisleiters (11a, 11b; 15) derart beabstandet voneinander erstrecken, dass die Abzweigleiter (12, 12b; 16) ausschließlich über den Basisleiter galvanisch gekoppelt sind,
wobei der wenigstens eine induktive Sensor (5a, 5b, 5c) beabstandet von dem Basisleiter (11a, 11b; 15), entlang dessen Längserstreckung angeordnet ist, **dadurch gekennzeichnet, dass** der induktive Sensor in Freibereichen der Sensorelektrode angeordnet ist, die durch die Abzweigleiter gebildet sind, wobei die Abzweigleiter mit unterschiedlichen Längen derart ausgebildet sind, dass sie den induktiven Sensor (5a, 5b, 5c) entlang eines Umfangabschnitts beabstandet umgeben.

2. Sensoreinrichtung nach Anspruch 1, wobei sämtliche Abzweigleiter (12, 12b; 16) gerade ausgebildet sind und in einem einheitlichen Abzweigwinkel zu dem Basisleiter (11a, 11b; 15) abzweigen.

3. Sensoreinrichtung nach Anspruch 2, wobei der Abzweigwinkel 90 Grad beträgt und somit die Abzweigleiter (12, 12b; 16) mit dem Basisleiter (11a, 11b; 15) eine Kammstruktur bilden.

4. Sensoreinrichtung nach einem der vorangehenden Ansprüche, wobei der induktive Sensor (5a, 5b, 5c) wenigstens eine Spulenanordnung aufweist, welche als spiralförmige Leiterbahn auf der Leiterplatte (2) ausgebildet ist.

5. Sensoreinrichtung nach einem der vorangehenden Ansprüche, wobei jeder Abzweigleiter (12, 12b; 16) sich mit einer über seine gesamte Länge konstanten Breite von dem Basisleiter (11a, 11b; 15) erstreckt.

6. Sensoreinrichtung nach einem der vorangehenden Ansprüche, wobei die Breite der Abzweigleiter mit größerer Entfernung von dem induktiven Sensor zunimmt.

7. Sensoreinrichtung nach einem der vorangehenden Ansprüche, wobei sämtliche Abzweigleiter (12, 12b; 16) von ihren benachbarten Abzweigleitern einheitliche Abstände aufweisen.

8. Sensoreinrichtung nach einem der vorangehenden Ansprüche, wobei die Abstände zwischen benachbarten Abzweigleitern zwischen der 0,5-fachen und 5-fachen der größeren Breite der benachbarten Abzweigleiter aufweisen.

9. Sensoreinrichtung nach einem der vorangehenden Ansprüche, wobei die Abzweigleiter eine Breite zwischen 0,1 mmm und 1 mm aufweisen und wobei die Abstände zwischen benachbarten Abzweigleitern zwischen 0,1 mm und 1 mm betragen.

10. Sensoreinrichtung nach einem der vorangehenden Ansprüche, wobei zwei Basisleiter (11a, 11b) mit jeweils zugeordneten Abzweigleitern (12a, 12b) ausgebildet sind, welche sich auf zwei Seiten des induktiven Sensors (5a, 5b, 5c) auf der Leiterplatte erstrecken, wobei die Abzweigleiter von jedem der Basisleiter in Richtung der Spulenanordnung abzweigen.

11. Sensoreinrichtung nach Anspruch 10, wobei die Basisleiter (11a, 11b) mit der Steuereinrichtung gekoppelt sind, ansonsten jedoch galvanisch voneinander getrennt sind.

12. Sensoreinrichtung nach einem der vorangehenden Ansprüche, wobei die Sensoreinrichtung auf einer Mehrschichtplatine ausgebildet ist, wobei die Sensorelektrode auf einer Lage der Mehrschichtplatine angeordnet ist und auf wenigstens einer weiteren Ebene der Mehrschichtplatine zu der Sensorelektrode eine deckungsgleiche Elektrode als Shield-Elektrode oder als Bezugselektrode ausgebildet ist.

## Claims

1. Sensor device for a motor vehicle, comprising
an at least single-layered printed circuit board (2) on which at least one sensor electrode (11a, 12a, 11b, 12b; 15, 16) of at least one capacitive sensor is formed,
at least one inductive sensor (5a, 5b, 5c) which is arranged on the printed circuit board (2)
a control device (10) coupled to the sensor electrode (11a, 12a, 11b, 12b; 15, 16) and the inductive sensor (5a, 5b, 5c), wherein
the sensor electrode comprises at least one elongated base conductor (11a, 11b; 15) and a plurality of branch conductors (12, 12b; 16) extending from the base conductor,
wherein the branch conductors (12, 12b; 16) extend along the base conductor (11a, 11b; 15) spaced apart from each other such that the branch conductors (12, 12b; 16) are galvanically coupled exclusively via the base conductor,
wherein the at least one inductive sensor (5a, 5b, 5c) is arranged spaced from the base conductor (11a, 11b; 15) along the longitudinal extension thereof,
**characterized in that**
the inductive sensor is arranged in free areas of the sensor electrode formed by the branch conductors, the branch conductors being formed with different lengths such that they surround the inductive sensor (5a, 5b, 5c) spaced along a circumferential portion thereof.

2. Sensor device according to claim 1, wherein all branch conductors (12, 12b; 16) are formed straight and branch at a uniform branch angle to the base conductor (11a, 11b; 15).

3. Sensor device according to claim 2, wherein the branch angle is 90 degrees and thus the branch conductors (12, 12b; 16) form a comb structure with the base conductor (11a, 11b; 15) .

4. Sensor device according to one of the preceding claims, wherein the inductive sensor (5a, 5b, 5c) has at least one coil arrangement which is formed as a spiral conductor track on the printed circuit board (2).

5. Sensor device according to any one of the preceding claims, wherein each branch conductor (12, 12b; 16) extends from the base conductor (11a, 11b; 15) with a width which is constant over its entire length.

6. Sensor device according to any of the preceding claims, wherein the width of the branch conductors increases with greater distance from the inductive sensor.

7. Sensor device according to any of the preceding claims, wherein all branch conductors (12, 12b; 16) have uniform distances from their adjacent branch conductors.

8. Sensor device according to any one of the preceding claims, wherein the distances between adjacent branch conductors have between 0.5 times and 5 times the larger width of the adjacent branch conductors.

9. Sensor device according to any one of the preceding claims, wherein the branch conductors have a width between 0.1 mm and 1 mm, and wherein the distances between adjacent branch conductors are between 0.1 mm and 1 mm.

10. Sensor device according to any one of the preceding claims, wherein two base conductors (11a, 11b) are formed with respective branch conductors (12a, 12b) extending on two sides of the inductive sensor (5a, 5b, 5c) on the printed circuit board, the branch conductors branching off from each of the base conductors in the direction of the coil arrangement.

11. Sensor device according to claim 10, wherein the base conductors (11a, 11b) are coupled to the control device but are otherwise galvanically isolated from each other.

12. Sensor device according to one of the preceding claims, wherein the sensor device is formed on a multilayer board, wherein the sensor electrode is arranged on one layer of the multilayer board and an electrode congruent with the sensor electrode is formed on at least one further layer of the multilayer board as a shield electrode or as a reference electrode.

## Revendications

1. Dispositif de détection pour un véhicule automobile, comprenant
une carte de circuit imprimé (2) au moins monocouche, sur laquelle est formée au moins une électrode de capteur (11a, 12a, 11b, 12b ; 15, 16) d'au moins un capteur capacitif,
au moins un capteur inductif (5a, 5b, 5c), qui est disposé sur la carte de circuit imprimé (2),
un dispositif de commande (10) qui est couplé à l'électrode de détection (11a, 12a, 11b, 12b ; 15, 16) et au capteur inductif (5a, 5b, 5c),
dans lequel l'électrode de détection comprend au moins un conducteur de base allongé (11a, 11b ; 15) et une pluralité de conducteurs de dérivation (12, 12b ; 16) s'étendant à partir du conducteur de base,
les conducteurs de dérivation (12, 12b ; 16) s'étendant le long du conducteur de base (11a, 11b ; 15) à une distance les uns des autres telle que les conducteurs de dérivation (12, 12b ; 16) sont couplés galvaniquement exclusivement par l'intermédiaire du conducteur de base,
l'au moins un capteur inductif (5a, 5b, 5c) étant disposé à distance du conducteur de base (11a, 11b ; 15), le long de l'extension longitudinale de celui-ci, **caractérisé en ce que** le capteur inductif est disposé dans des zones libres de l'électrode de capteur, qui sont formées par les conducteurs de dérivation, les conducteurs de dérivation étant réalisés avec des longueurs différentes de telle sorte qu'ils entourent le capteur inductif (5a, 5b, 5c) à distance le long d'une section périphérique.

2. Dispositif de détection selon la revendication 1, dans lequel tous les conducteurs de dérivation (12, 12b ; 16) sont formés de manière rectiligne et se ramifient selon un angle de dérivation uniforme par rapport au conducteur de base (11a, 11b ; 15).

3. Dispositif de détection selon la revendication 2, l'angle de dérivation étant de 90 degrés et les conducteurs de dérivation (12, 12b ; 16) formant ainsi une structure en peigne avec le conducteur de base (11a, 11b ; 15).

4. Dispositif de détection selon l'une quelconque des revendications précédentes, dans lequel le capteur inductif (5a, 5b, 5c) comporte au moins un agencement de bobines qui est réalisé sous la forme d'une piste conductrice en spirale sur la carte de circuit imprimé (2).

5. Dispositif de détection selon l'une quelconque des revendications précédentes, dans lequel chaque conducteur de dérivation (12, 12b ; 16) s'étend à partir du conducteur de base (11a, 11b ; 15) avec une largeur constante sur toute sa longueur.

6. Dispositif de détection selon l'une quelconque des revendications précédentes, dans lequel la largeur des conducteurs de dérivation augmente à mesure que l'on s'éloigne du capteur inductif.

7. Dispositif de détection selon l'une quelconque des revendications précédentes, dans lequel tous les conducteurs de dérivation (12, 12b ; 16) présentent des distances uniformes par rapport à leurs conducteurs de dérivation voisins.

8. Dispositif de détection selon l'une quelconque des revendications précédentes, dans lequel les distances entre des conducteurs de dérivation adjacents sont comprises entre 0,5 fois et 5 fois la plus grande largeur des conducteurs de dérivation adjacents.

9. Dispositif de détection selon l'une quelconque des revendications précédentes, dans lequel les conducteurs de dérivation ont une largeur comprise entre 0,1 mmm et 1 mm et dans lequel les distances entre des conducteurs de dérivation adjacents sont comprises entre 0,1 mm et 1 mm.

10. Dispositif de détection selon l'une quelconque des revendications précédentes, dans lequel deux conducteurs de base (11a, 11b) sont formés avec des conducteurs de dérivation respectifs (12a, 12b) qui s'étendent sur deux côtés du capteur inductif (5a, 5b, 5c) sur la carte de circuit imprimé, les conducteurs de dérivation se ramifiant à partir de chacun des conducteurs de base en direction de l'ensemble de bobines.

11. Dispositif de détection selon la revendication 10, dans lequel les conducteurs de base (11a, 11b) sont couplés au dispositif de commande, mais sont par ailleurs séparés galvaniquement les uns des autres.

12. Dispositif de détection selon l'une quelconque des revendications précédentes, le dispositif de détection étant réalisé sur une platine multicouche, l'électrode de détection étant disposée sur une couche de la platine multicouche et une électrode identique à l'électrode de détection étant réalisée sur au moins un autre plan de la platine multicouche en tant qu'électrode de protection ou en tant qu'électrode de référence.
